# FASCICULE DE BREVET EUROPEEN

(11) **EP 0 645 927 B1**
(45) Date de publication et mention de la délivrance du brevet: **12.05.1999**
(21) Numéro de dépôt: 94402124.5
(22) Date de dépôt: 23.09.1994
(51) Int. Cl.: H04N 5/445

(54) **Procédé et dispositif d'affichage et de traitement des données de vidéotexte ou de téléphone**
Verfahren und Vorrichtung zur Anzeige und Verarbeitung von Videotextdaten
Method and apparatus for the display and processing of teletext data

(30) Priorité: 28.09.1993 FR 9311502
(43) Date de publication de la demande: 29.03.1995
(73) Titulaire: THOMSON multimedia, 92648 Boulogne Cédex (FR)
(72) Inventeur: Staron, Alain, F-92402 Courbevoie Cedex (FR)
(74) Mandataire: Ruellan-Lemonnier, Brigitte

(56) Documents cités:
- GB-A- 2 188 458

## Description

La présente invention concerne un procédé d'affichage de données de vidéotexte ou de téléphone, ainsi qu'un perfectionnement de ce procédé permettant de contrôler, à partir de ces données affichées, les programmes reçus par un téléviseur. La présente invention concerne aussi un dispositif de mise en oeuvre de ce procédé et de son perfectionnement.

Le service télétexte et ses équivalents en dehors de l'Europe, permettent d'afficher sur un écran de télévision des pages de vidéotexte, c'est à dire un ensemble de lignes de caractères alphanumériques en général en couleur, donnant de nombreuses et diverses informations, comme par exemple les informations d'actualité, la météo ou les programmes télédiffusés. Les signaux correspondant au vidéotexte sont transmis en même temps que les signaux vidéo et audio sur les différents canaux. Un certain nombre de pages sont affichables et les informations qui y sont contenues sont mises à jour régulièrement. Un exemple de vidéotexte et de ses spécifications est décrit dans les "Spécifications Vidéotex de visualisation et de codage" C.C.E.T.T. aux éditions D.A.I.I.

Actuellement il existe plusieurs possibilités d'affichage des pages de vidéotexte, soit plein écran, soit en surimpression sur les images de l'émission en cours, celles-ci étant alors en partie masquées. Par ailleurs, le téléspectateur dispose avec ce service d'un très grand nombres d'informations sans pour autant les utiliser autrement que comme de simples informations à lire.

GB-A-2 188 458 décrit une télécommande avec un dispositif d'affichage des commandes.

La présente invention permet d'offrir au téléspectateur un meilleur confort d'utilisation du vidéotexte en lui permettant d'avoir sous les yeux les images télévisées et les pages de vidéotexte sans que les unes et les autres n'interfèrent entre elles.

Le procédé selon l'invention permet de visualiser les informations contenues dans les pages de vidéotexte sans devoir être face au téléviseur, supprimant ainsi toutes les contraintes de distance de lecture de ces informations existant dans l'art antérieur.

D'autre part, le téléspectateur peut visualiser les pages de vidéotexte sans que le téléviseur ne soit allumé.

Un perfectionnement de la présente invention permet au téléspectateur de contrôler les programmes de télévision non plus à partir de touches numériques mais à partir du nom des programmes affichés par le télétexte.

D'une manière générale, la présente invention offre une meilleure convivialité au téléspectateur dans la lecture des pages du vidéotexte et dans la commande des programmes de son téléviseur.

La présente invention peut aussi être utilisée pour afficher des informations reçues par le téléphone. Ces données peuvent être du type son ou du type "minitel", elles sont traitées de la même manière que les données de vidéotexte et offrent donc les mêmes avantages que ceux cités plus hauts.

En effet, la présente invention concerne un procédé d'affichage de données de vidéotexte ou transmises par le téléphone qui est caractérisé en ce qu'il comporte les étapes suivantes:
. réception et décodage desdites données par un dispositif récepteur/décodeur situé dans le téléviseur ou connecté à celui-ci,
. transmission des données à un dispositif de commande du téléviseur et/ou d'un magnétoscope,
. réception et affichage desdites données sur un dispositif d'affichage du dispositif de commande.

Il peut aussi comporter une étape supplémentaire d'encodage dans un format optimisant l'affichage sur un écran des données de vidéotexte, une fois ceux-ci reçus et décodés, et les signaux obtenus peuvent être modulés avant d'être transmis. Tout ou une partie des données de vidéotexte d'un ou de plusieurs canaux est stocké en mémoire (située de préférence dans le panneau de commande) et affiché, sur commande de l'utilisateur.

De plus, un perfectionnement du procédé selon l'invention est que les données sont affichées sur un écran tactile et sont traitées par un microprocesseur comportant un logiciel de reconnaissance de syntaxe ou d'un code associé permettant, par sélection d'une ligne par pression de l'utilisateur sur la zone (en générale, une ligne) de l'écran tactile, de programmer un téléviseur ou un magnétoscope.

La présente invention concerne aussi un système d'affichage de données de vidéotexte ou de données reçues par le téléphone type son ou minitel, mettant en oeuvre le procédé selon l'invention. Il comporte au moins un récepteur/décodeur de signaux de vidéotexte, un dispositif de transmission de ces données destinées à un panneau de commande comportant un dispositif de réception de ces données transmises ainsi qu'un dispositif d'affichage de ces signaux. Ce dispositif d'affichage peut être un écran tactile. Dans ce cas, il est commandé par un microprocesseur comportant une fonction de reconnaissance de syntaxe ou de codes d'identification des caractères affichés sur le dispositif d'affichage et permet de programmer sur le téléviseur ou sur le magnétoscope une émission, automatiquement par simple pression sur la zone de l'écran du panneau de commande correspondant aux caractères identifiant l'émission en question.

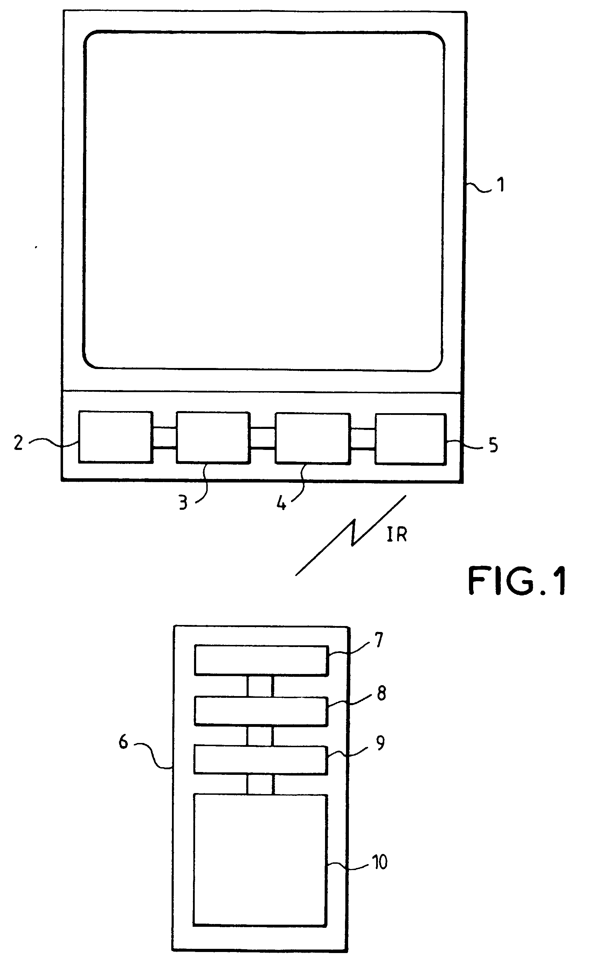

La présente invention sera mieux comprise et des avantages supplémentaires apparaitront à la lecture de la description qui va suivre, illustrée par la figure 1 qui représente un mode de réalisation de l'invention.

Sur la figure 1 est représentée un téléviseur 1 comportant au moins un tuner 2 et éventuellement un décodeur de télétexte 3 permettant au téléviseur de recevoir, de stocker en mémoire et d'afficher des données de vidéotexte. La description qui va suivre concerne les données de télétexte, mais le procédé selon l'invention peut aussi traiter des données reçues par téléphone.

Dans le cas du télétexte, qui est le type de vidéotexte utilisé en Europe, le tuner est de préférence un tuner du type tuner PIP (pour "Picture In Picture" en langue Anglaise) balayant le spectre des canaux, afin d'avoir un accès récurrent à chacun des services de vidéotexte des différents canaux, et transmettant des signaux du type CVBS (pour "Color Video Burst Signal" en langue Anglaise, standard international) au dispositif de réception et de décodage adapté par exemple au format CEEFAX. Ce dernier dispositif peut être par exemple du type TPU3040 de ITT ou SDA5273 de Siemens.

Dans la suite de la description, les données considérées sont les données télétexte, mais l'invention peut aussi s'appliquer au traitement de tous les types de vidéotexte, ainsi que les données transmises par téléphone, qu'elles soient alphanumériques du type "minitel" ou sonores. Dans le cas des signaux reçus par téléphone, il est nécessaire d'utiliser un modem correspondant, comme par exemple le dispositif LOTTI de ITT qui reçoit des données téléphone et fournit des données en ASCII ("American Code for Information Interchange" en langue Anglaise). Celui-ci peut être connecté au téléviseur, intégré à celui-ci, ou compris dans un boitier modem-émetteur émettant directement vers la télécommande. Il peut aussi être intégré à la télécommande, celle-ci pouvant faire office en plus de dispositif de commande du téléviseur et/ou du magnétoscope, de téléphone et même de téléphone sans fil.

Avantageusement, les données télétextes sont ensuite encodées par un encodeur 4 dans un format de transmission de données digitales particulier qui permet, si on le désire, de s'affranchir du format CEEFAX, pour être modulées et émises par l'intermédiaire d'un émetteur 5. Cet émetteur est de préférence un émetteur à ondes radios (RF), mais peut aussi être à ondes infra rouges (IR) ou transmettre les signaux par l'intermédiaire du secteur. Un exemple d'un tel dispositif peut être la télécommande IR "Black Quarz" RCT8000 de Thomson ou M34230 de Mitsubishi. Avantageusement, cette communication des données peut être faite même lorsque le téléviseur est en "stand by", c'est à dire, lorsque le tuner PIP, le décodeur télétexte, l'émetteur et le microprocesseur restant alimentés. Ceci représente un avantage supplémentaire de l'invention, comme cela est décrit plus loin.

Le dispositif de commande 6 du téléviseur 1, du type télécommande, comporte un récepteur 7 composé au moins d'une antenne et d'un démodulateur des signaux émis par le téléviseur 1. Un exemple d'un tel dispositif est le récepteur IR GP1U58XY de Sharp utilisé dans le chassis ICC10. Le panneau de commande 6 comporte d'autre part, une mémoire dans laquelle sont stockées toutes les données télétexte formatées reçues par le récepteur 7. Cette mémoire est du type DRAM et peut par exemple recevoir et transmettre des données ASCII. A chaque fois que de nouvelles données télétexte sont reçues, elles sont décodées par le décodeur télétexte 3, éventuellement encodées dans le format considéré, émises par l'émetteur 5, reçues par le récepteur 7 et le contenue de la mémoire 8 est mis à jour.

Cette mémoire de stockage des données télétexte peut être située entre l'encodeur 4 et l'émetteur 5 du téléviseur, cependant il est préférable de placer la mémoire dans le dispositif de commande afin de limiter le nombre de données transmises entre le téléviseur et le dispositif de commande pour permettre un meilleur confort d'utilisation.

La mémoire 8 permet de stocker tout ou une partie des pages (comme par exemple une vingtaine de pages correspondant à l'ensemble des informations d'actualité) d'un ou plusieurs services télétexte. Elle peut aussi ne charger que les quelques pages qui suivent et/ou précèdent la page sélectionnée par l'utilisateur.

Le dispositif de commande comporte un microprocesseur 9 associé à la mémoire 8, et qui commande un dispositif d'affichage 10 du type écran plat. Ce microprocesseur affiche les données formatées sur l'écran 10. Le format dans lequel ont été encodées les données télétexte est choisi afin d'optimiser l'affichage qui doit être au moins alphanumérique (de préférence 24 lignes et 40 caractères par ligne).

Par ailleurs, le dispositif de commande est muni classiquement d'une alimentation, d'un émetteur de signaux de commande en général IR et de touches de commandes permettant de contrôler les paramètres du téléviseur et ceux de l'écran du panneau de commande affichant les pages de télétexte. L'écran du panneau de commande peut être un écran à cristaux liquides ou un panneau à plasma.

Ce dispositif selon l'invention met en oeuvre le procédé suivant:
. les données télétexte son reçues et décodées par un dispositif récepteur/décodeur situé dans le téléviseur ou dans un magnétoscope, ou connecté à celui-ci,
. éventuellement encodées dans un certain format adapté au type d'affichage désiré,
. modulées et émises du téléviseur vers le dispositif de commande,
. reçues par celui-ci et stockées en mémoire,
. puis affichées sur un dispositif d'affichage.

Ainsi, le téléspectateur peut voir en même temps l'image sur son téléviseur et les pages de télétexte sur sa télécommande. Un mode préférenciel d'affichage des pages de vidéotexte peut être par exemple, d'afficher d'un côté de l'écran la page correspondant au sommaire du service, cette page étant affichée en permanence, et de l'autre les pages que l'utilisateur peut faire défiler. Un autre mode d'affichage peut être un affichage de deux pages à la fois permettant à l'utilisateur de faire défiler les pages une à une à la manière des pages d'un livre que l'on tourne. Dans le cas de ce dernier mode d'affichage et pour une meilleure convivialité, le défilement des pages peut être commandé par l'intermédiaire d'un bouton de défilement, c'est à dire, un bouton de commande de type "chenille" qui, lorsque l'utilisateur le manipule en le faisant coulisser, permet d'afficher une ou plusieurs pages suivantes ou précédentes.

Un avantage supplémentaire de la présente invention est que l'utilisateur peut afficher le programme de télévision et voir ainsi un programme tout en ayant sous les yeux le programme des autres chaines.

Par l'utilisation d'un microprocesseur simple utilisant un algorithme pouvant reconnaitre les caractères affichés sur l'écran ou un code d'identification associé, le procédé selon l'invention peut afficher sur l'écran du dispositif de commande, une sélection de programmes en traitant les dates, heures et genres des émissions du programme. Un tel algorithme est à la portée d'un homme du métier.

Il peut, par exemple, afficher la liste des émissions passant sur les autres chaînes, avec en surbrillance la ligne sur laquelle est affichée l'émission qui passe à ce moment là sur l'écran du téléviseur. Il peut aussi afficher la liste des programmes à venir sur la chaîne à l'écran du téléviseur à ce moment là. Une autre application avantageuse de l'invention peut être la sélection par un logiciel d'un certain genre d'émission, par exemple, le thème "sport" regroupant les nouvelles de sport et les programmes à venir traitant de sport. Dans ce cas, sont stockées en mémoire les mots permettant la reconnaissance par le logiciel, ou les données correspondant aux codes associés à chaque émission.

Un autre logiciel peut permettre à l'utilisateur de présélectionner, grâce au clavier de sa télécommande, une émission pour la voir sélectionnée sur l'écran du téléviseur, ou un type de programme, l'écran du dispositif affichant les émission correspondant à ce programme qui sont mémorisées grâce au télétexte. Un autre perfectionnement de ce procédé peut consister à enregistrer en mémoire les commandes de l'utilisateur, soit lorqu'il les saisit sur le dispositif soit lorsqu'il les sélectionne par pression sur l'écran tactile, et, après par exemple une certaine récurrence, à les afficher automatiquement sur l'écran du panneau de commande et/ou sur l'écran du téléviseur lorsque l'utilisateur met en marche son téléviseur par la télécommande.

Dans le cas où le téléviseur et la télécommande communiquent par ondes radio ou par le secteur, on constate qu'un autre avantage de la présente invention est que l'utilisateur peut consulter son panneau de commande et toutes les informations qui y sont affichées tout en étant dans une autre pièce que le téléviseur, celui-ci pouvant être éteint, ou plus précisément en mode "veille", c'est à dire que l'écran n'est pas allumé. La fonction de la télécommande est alors celle d'un simple livre dont le contenu est celui des télétextes.

Dans le cas où le dispositif de commande reçoit des données par le téléphone, ce dispositif de commande peut aussi servir de téléphone.

Les différents éléments du dispositif selon la présente invention (encodeur 4, émetteur 5, panneau de commande 6, récepteur 7, mémoire 8, microprocesseur 9 et écran 10) sont des éléments qui ne présentent pas de difficultés de conception et de fabrication pour un homme du métier.

Un perfectionnement de la présente invention est l'utilisation comme dispositif d'affichage 10 d'un écran tactile et d'un logiciel de traitement des données affichées.

A partir, par exemple, du mode préférenciel d'affichage évoqué plus haut et d'un écran tactile, l'utilisateur peut en appuyant sur la zone de l'écran sur laquelle est affiché un des titres de la page sommaire, voir affichée sur l'autre page l'information correspondant au titre sélectionné grâce au microprocesseur qui affiche la page correspondante en la reconnaissant à partir du numéro de page affiché en face du titre. Le titre en question étant mis par exemple en surbrillance sur l'autre page toujours affichée.

Ce type de fonction de reconnaissance de caractère/syntaxe du microprocesseur est une fonction couramment utilisée dans des microprocesseurs par l'homme du métier.

Dans le cas où un code d'identification (type "showview") d'une émission est transmis en même temps que les signaux vidéotexte, l'utilisateur peut programmer son téléviseur ou son magnétoscope automatiquement en appuyant sur la zone de l'écran sur laquelle est affiché le nom et eventuellement le code d'identification de l'émission sélectionnée.

Si aucun code d'identification n'est transmis avec le vidéotexte, le microprocesseur peut, par reconnaissance de l'heure et de la date associée à l'émission et affichée sur la même zone que celle-ci, reconstituer grâce à l'algorithme adéquat un code d'identification et permettre la programmation automatique du téléviseur ou du magnétoscope.

Une autre application de l'invention est la possibilité, grâce à l'écran tactile de sélectionner une émission et d'afficher automatiquement en paralèlle la liste des programmes en cours sur les autres canaux.

Comme on peut le voir, la télécommande peut devenir grâce au procédé selon l'invention et à ses perfectionnements, de véritables livres interactifs que peut feuilleter l'utilsateur, celui-ci pouvant d'une manière très simple commander les programmes affichés sur le téléviseur et la programmation du téléviseur et du magnétoscope.

La présente invention s'applique à tous les type de téléviseurs pouvant recevoir au moins un service de videotexte ou des données par téléphone directement ou par l'intermédiaire d'un télécommande indépendante.

## Revendications

1. Procédé d'affichage de données de vidéotexte ou transmises par le téléphone, caractérisé en ce qu'il comporte les étapes suivantes:
. réception et décodage desdites données par un dispositif récepteur/décodeur (2) situé dans le téléviseur (1) ou un magnétoscope, ou connecté à celui-ci,
. transmission des données à un dispositif de commande (6) du téléviseur (1) et/ou du magnétoscope,
. réception et affichage desdites données sur un dispositif d'affichage (10) dudit dispositif de commande (6).

2. Procédé selon la revendication 1 caractérisé en ce qu'il comporte une étape supplémentaire d'encodage dans un format optimisant l'affichage sur un écran (10) desdites données, une fois celles-ci reçues et décodées.

3. Procédé selon l'une quelconque des revendications précédentes caractérisé en ce que les données sont modulées avant d'être transmises au dispositif de commande (6).

4. Procédé selon l'une quelconque des revendications précédentes caractérisé en ce que toutes les données ou une partie de ces données sont stockées en mémoire (8) et affichées sur commande de l'utilisateur.

5. Procédé selon l'une quelconque des revendications précédentes, caractérisé en ce que le microprocesseur commandant l'écran (10) du dispositif de commande (6) est muni d'un logiciel qui permet de sélectionner soit par reconnaissance automatique du code associé correspondant au genre de l'émission, soit par reconnaissance de la syntaxe des caractères transmis au dispositif d'affichage (10), les données correspondant au programme des émissions reçues par le téléviseur (1) et d'afficher celles-ci par genre.

6. Procédé selon l'une quelconque des revendications précédentes caractérisé en ce que les données sont affichées sur un écran tactile (10) du dispositif de commande (6) et sont traitées par un microprocesseur comportant un logiciel de reconnaissance des caractères affichés sur le dispositif d'affichage (10), permettant, par sélection d'une ligne, de programmer le téléviseur (1) et/ou le magnétoscope.

7. Système permettant l'affichage de données de vidéotexte ou transmises par le téléphone sur un écran de téléviseur caractérisé en ce qu'il comporte un dispositif récepteur/décodeur (2,3) de ces données, un dispositif de transmission (5) de ces données destinées à un dispositif de commande (6) comportant un dispositif de réception (7) de ces données transmises ainsi qu'un dispositif d'affichage (10).

8. Système d'affichage selon la revendication 7, caractérisé en ce que le dispositif d'affichage (10) est un écran plat du type à cristaux liquides ou à plasma.

9. Système d'affichage selon la revendication 8 caractérisé en ce que le dispositif d'affichage (10) est un écran tactile.

10. Système d'affichage selon la revendication 9 caractérisé en ce qu'il est commandé par un microprocesseur (9) comportant une fonction de reconnaissance de la syntaxe ou du code d'identification des caractères affichés sur le dispositif d'affichage (10)

11. Système d'affichage selon la revendication 7 ou 8 caractérisé en ce qu'il met en oeuvre le procédé selon l'une quelconque des revendications 1 à 5.

12. Système d'affichage selon l'une quelconque des revendications 9 et 10, caractérisé en ce qu'il met en oeuvre le procédé selon la revendication 6.

## Patentansprüche

1. Verfahren zur Anzeige von Videotext-Daten oder von über Telefon übertragenen Bildschirmtext-Daten, gekennzeichnet durch folgende Schritte:
· Empfang und Dekodierung der Daten durch eine Empfangs/Dekoder-Einheit (2), die in dem Fernsehgerät (1) oder einem Videorekorder angeordnet oder mit diesem verbunden ist,
· Übertragung der Daten zu einer Bedieneinheit (6) des Fernsehgeräts (1) und/oder des Videorekorders,
· Empfang und Anzeige der Daten auf einer Anzeigeeinheit (10) der Bedieneinheit (6).

2. Verfahren nach Anspruch 1, gekennzeichnet durch einen zusätzlichen Abschnitt zur Kodierung in ein Format, das die Anzeige der Daten auf einem Bildschirm (10) optimiert, wenn diese einmal empfangen und dekodiert wurden.

3. Verfahren nach einem der vorangehenden Ansprüche, dadurch gekennzeichnet, daß die Daten moduliert werden, bevor sie zu der Bedieneinheit (6) übertragen werden.

4. Verfahren nach einem der vorangehenden Ansprüche, dadurch gekennzeichnet, daß alle Daten oder ein Teil der Daten in einem Speicher (8) gespeichert und aufgrund eines Steuerbefehls des Benutzers angezeigt werden.

5. Verfahren nach einem der vorangehenden Ansprüche, dadurch gekennzeichnet, daß der den Bildschirm (10) der Bedieneinheit (6) steuernde Mikroprozessor mit einer Software versehen ist, die es ermöglicht, die Daten, die dem Programm der durch das Fernsehgerät (1) empfangenen Sendungen entsprechen, auszuwählen und diese je nach Art anzuzeigen, entweder durch automatische Erkennung des der Art der Sendung entsprechenden Kodes oder durch Erkennung der Syntax der zu der Anzeigevorrichtung (10) übertragenen Zeichen.

6. Verfahren nach einem der vorangehenden Ansprüche, dadurch gekennzeichnet, daß die Daten auf einem Bildschirm (10) der Bedieneinheit (6) angezeigt und durch einen Mikroprozessor verarbeitet werden, der eine Software zum Erkennen der auf der Anzeigeeinheit (10) angezeigten Zeichen enthält und es ermöglicht, durch Auswahl einer Zeile das Fernsehgerät (1) und/oder den Videorekorder zu programmieren.

7. System zur Anzeige der Videotext-Daten oder der durch Telefon übertragenen Bildschirmtext-Daten auf einem Bildschirm des Fernsehgeräts, dadurch gekennzeichnet, daß das System eine Vorrichtung mit einem Empfänger/Dekoder (2, 3) für diese Daten enthält, wobei eine Übertragungseinheit (5) dieser für eine Bedieneinheit (6) bestimmten Daten eine Empfangseinheit (7) für diese übertragenen Daten sowie eine Anzeigeeinheit (10) enthält.

8. System zur Anzeige nach Anspruch 7, dadurch gekennzeichnet, daß die Anzeigeeinheit (10) ein flacher Flüssigkristall- oder Plasma-Bildschirm ist.

9. System zur Anzeige nach Anspruch 8, dadurch gekennzeichnet, daß die Anzeigeeinheit (10) ein Tastschirm oder Druckschirm ist.

10. System zur Anzeige nach Anspruch 9, dadurch gekennzeichnet, daß es durch einen Mikroprozessor (9) gesteuert wird, der eine Erkennungsfunktion der Syntax oder des Identifizierungskodes der auf der Anzeigeeinheit (10) angezeigten Schriftzeichen enthält.

11. System zur Anzeige nach Anspruch 7 oder 8, dadurch gekennzeichnet, daß es das Verfahren nach einem der Ansprüche 1 bis 5 durchführt.

12. System zur Anzeige nach einem der Ansprüche 9 und 10, dadurch gekennzeichnet, daß es das Verfahren nach Anspruch 6 durchführt.

## Claims

1. Process for displaying videotext data or data sent via the telephone, characterized in that it comprises the following steps:
• reception and decoding of the said data by a receiver/decoder device (2) situated in the television (1) or a video recorder, or connected to the latter,
• sending of the data to a control device (6) for the television (1) and/or for the video recorder,
• reception and display of the said data on a display device (10) of the said control device (6).

2. Process according to Claim 1 characterized in that it comprises an additional step of encoding in a format optimizing the display on a screen (10) of the said data, once the latter have been received and decoded.

3. Process according to any one of the preceding claims, characterized in that the data are modulated before being sent to the control device (6).

4. Process according to any one of the preceding claims, characterized in that all the data or some of these data are stored in memory (8) and displayed on command from the user.

5. Process according to any one of the preceding claims, characterized in that the microprocessor controlling the screen (10) of the control device (6) is furnished with software which makes it possible to select either by automatic recognition of the associated code corresponding to the kind of the transmission, or by recognition of the syntax of the characters sent to the display device (10), the data corresponding to the programme of transmissions received by the television (1) and to display them by kind.

6. Process according to any one of the preceding claims, characterized in that the data are displayed on a touch screen (10) of the control device (6) and are processed by a microprocessor comprising software for recognizing the characters displayed on the display device (10), making it possible, by selecting a line, to programme the television (1) and/or the video recorder.

7. System allowing the display of videotext data or data sent via the telephone on a television screen characterized in that it comprises a receiver/decoder device (2, 3) for these data, a device (5) for sending these data towards a control device (6) comprising a device (7) for receiving these sent data as well as a display device (10).

8. Display system according to Claim 7, characterized in that the display device (10) is a flat screen of the liquid-crystal or plasma type.

9. Display system according to Claim 8, characterized in that the display device (10) is a touch screen.

10. Display system according to Claim 9, characterized in that it is controlled by a microprocessor (9) comprising a function for recognizing the syntax or the identification code of the characters displayed on the display device (10).

11. Display system according to Claim 7 or 8, characterized in that it implements the process according to any one of Claims 1 to 5.

12. Display system according to either of Claims 9 and 10, characterized in that it implements the process according to Claim 6.
